# EUROPEAN PATENT APPLICATION

(11) **EP 3 467 158 A1**
(43) Date of publication of application: **10.04.2019**
(21) Application number: 17806697.3
(22) Date of filing: 30.05.2017
(51) Int. Cl.: C30B 15/10, B23K 9/00, C30B 29/20

(54) **CRUCIBLE**

(30) Priority: 30.05.2016 JP 2016107210
(71) Applicant: Kyocera Corporation, Kyoto-shi, Kyoto 612-8501 (JP)
(72) Inventor: KIZAKI, Takayasu, Kyoto-shi Kyoto 612-8501 (JP)
(74) Representative: Viering, Jentschura & Partner mbB Patent- und Rechtsanwälte
(86) International application number: PCT/JP2017/020149
(87) International publication number: WO 2017/209144

(57) **Abstract**

In one embodiment, a crucible contains iridium or platinum as a main ingredient, and includes a bottom part and a tubular part. The tubular part includes a plurality of segments and an annular first thick part at a position at which the segments are adjacent to each other. In another embodiment, a crucible contains iridium or platinum as a main ingredient, and includes a bottom part and a tubular part. The tubular part includes a plurality of segments and an annular first welded part at a position at which the segments are adjacent to each other.

## Description

### TECHNICAL FIELD

The present embodiment relates to a crucible used for a single crystal growth device.

### BACKGROUND ART

A metal crucible is used as a crucible for a single crystal growth device in accordance with vertical Bridgeman (VB) method, Kyropulos (KY) method, CZ (Czochralski) method, or the like. A crucible composed of iridium, molybdenum, tungsten, or alloy composed mainly of these has been known particularly for single crystal growth of high melting point materials, such as sapphire (single crystal alumina) (refer to, for example, Japanese Unexamined Patent Publication No. 2010-52993).

Japanese Unexamined Patent Publication No. 5-148074 and Japanese Unexamined Patent Publication No. 2006-205200 respectively disclose methods for manufacturing a crucible with which a rectangular plate serving as a side part is made into a cylindrical shape, and the side part is joined to a circular plate serving as a bottom part by welding.

A crucible for single crystal growth tends to deform due to a volume change during solidification of melt, a difference of thermal expansion coefficients between the crucible and a solidified matter, or the like. Deformation of the crucible may hinder heat equalization of the crucible, and may interfere with a circumferential member. In the worst case, the crucible may be broken.

Once the crucible is oxidized (altered) by the melt, the crucible becomes prone to breakage during solidification. From the viewpoint of oxidization, iridium and platinum are preferred to molybdenum, tungsten, or the like. However, because iridium and platinum are expensive materials, the crucible needs to be durable against repeated use in order that the crucible is worth a purchase cost therefor. In order to cope with increasing size of single crystal to be grown for the purpose of improving the recent mass productivity, the crucible size becomes larger. The large-size crucible needs to be much less likely to deform because partial difference in heat distribution and difference in stress distribution become larger. A large-size crucible composed mainly of iridium or platinum is more expensive and therefore needs to be durable even when used a plurality of times.

### SUMMARY

In one embodiment, a crucible contains iridium or platinum as a main ingredient, and includes a bottom part and a tubular part. The tubular part includes a plurality of segments and an annular thick part at a position at which the segments are adjacent to each other.

In another embodiment, a crucible contains iridium or platinum as a main ingredient, and includes a bottom part and a tubular part. The tubular part includes a plurality of segments and an annular first welded part at a position at which the segments are adjacent to each other.

### BRIEF DESCRIPTION OF THE DRAWINGS

FIG. 1 is a sectional view illustrating one embodiment of a crucible of the present disclosure;
FIG. 2 is a sectional view illustrating other embodiment of the crucible of the present disclosure;
FIG. 3 is a sectional view illustrating other embodiment of the crucible of the present disclosure;
FIG. 4 is a sectional view illustrating other embodiment of the crucible of the present disclosure;
FIG. 5 is a sectional view illustrating other embodiment of the crucible of the present disclosure;
FIG. 6 is a sectional view illustrating other embodiment of the crucible of the present disclosure;
FIG. 7 is a sectional view illustrating other embodiment of the crucible of the present disclosure; and
FIG. 8 is a sectional view illustrating other embodiment of the crucible of the present disclosure.

### EMBODIMENTS

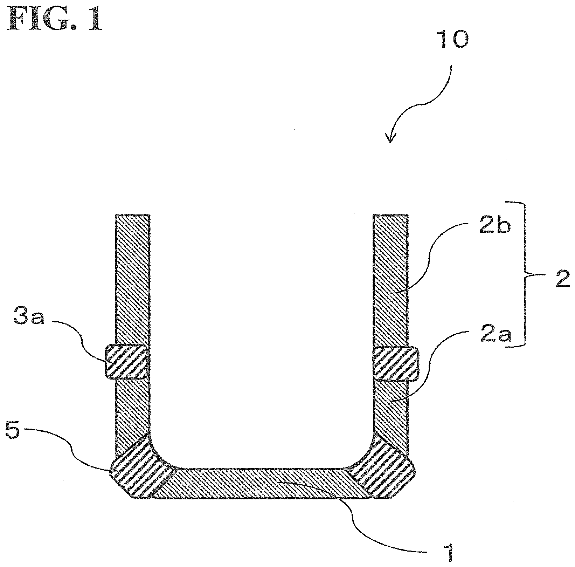

A crucible 10 of the present embodiment is described with reference to the drawings. FIGs. 1 to 4 are sectional views respectively illustrating a plurality of embodiments.

The crucible 10 contains iridium or platinum, and includes a bottom part 1 and a tubular part 2. The tubular part 2 is composed of a plurality of segments. An annular thick part 3 is disposed at a position at which the segments are adjacent to each other. The crucible 10 used for single crystal growth is a relatively large-size crucible in which both a diameter (φ) of the bottom part 1 and height are approximately 100 mm or more. The tubular part 2 is composed of a first segment 2a and a second segment 2b. The crucible 10 illustrated in FIG. 1 includes the bottom part 1, the first segment 2a that connects to the bottom part 1, the second segment 2b that connects to the first segment 2a, and the annular first thick part 3a at a position at which the first segment 2a is adjacent to the second segment 2b. The first thick part 3a has a great thickness and serves as a so-called reinforcing ring. The crucible 10 including the first thick part 3a is less likely to deform.

The first thick part 3a and individual thick parts described later of the present embodiment are formed by welding a plurality of segments constituting the crucible 10. Parts formed by welding are indicated by thick oblique hatching being different from that of the tubular part 2 in each of the drawings.

The crucible 10 is less susceptible to strength deterioration because cracks occurred along with growth of crystals of materials constituting the crucible 10 (iridium or platinum in the present embodiment) depending on thermal history are less likely to develop by having the first thick part 3a. The crucible 10 is excellent in strength and less likely to deform also from this point of view.

The first thick part 3a is disposed on an outer periphery of the crucible 10. In other words, the first thick part 3a protrudes outward from an outer peripheral surface of the crucible 10. The above cracks or the like tend to occur on the outer peripheral surface of the crucible 10. Since the first thick part 3a protrudes outward, the development of the cracks can be effectively reduced. Therefore, the strength deterioration or the like due to the cracks or the like is reduced effectively.

When a main ingredient of the crucible 10 of the present embodiment is iridium, the crucible 10 contains, besides iridium, alloy containing iridium. The term "main ingredient" denotes an ingredient whose mass ratio exceeds 50% relative to a total amount of the crucible 10. This is also true for platinum. Because iridium and platinum are less likely to be oxidized than molybdenum, tungsten, or the like, the crucible 10 is particularly suitable for manufacturing oxide single crystals, such as lithium tantalate. Iridium is also suitable for manufacturing sapphire single crystals because iridium is less likely to be oxidized at a melting point of sapphire (approximately 2050°C) and is stable.

Alternatively, the crucible 10 may also include a bottom thick part 5 at a boundary portion between the bottom part 1 and the tubular part 2, namely, at a corner portion between the bottom part 1 and the tubular part 2 as illustrated in FIG. 1. The crucible 10 is much less likely to deform or the like by having the bottom thick part at the corner portion where stress or like tends to be concentrated.

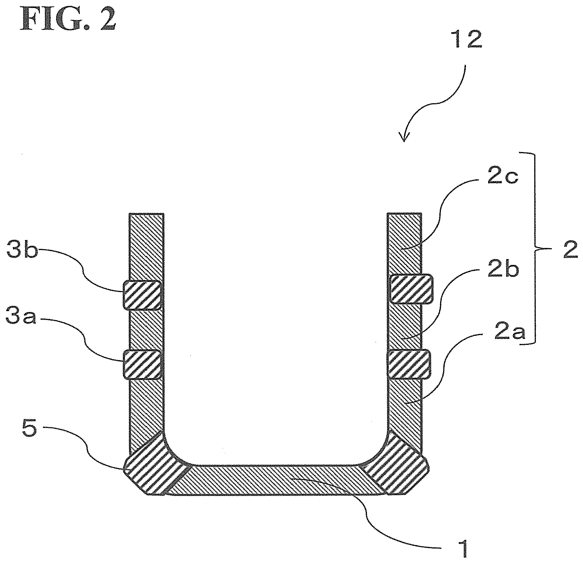

FIGs. 2, 3, and 4 are sectional views respectively illustrating other embodiments. As in the case of a crucible 12 illustrated in FIG. 2, the crucible may include a larger number of segments (a first segment 2a, a second segment 2b, and a third segment 2c) and a plurality of thick parts 3 (a first thick part 3a and a second thick part 3b) than the crucible 10 illustrated in FIG. 1. Specifically, when N is a natural number of 1 or more, the tubular part 2 may include N+1 segments, and N thick parts 3 respectively joined to these segments may be included. For example, when N=2, the crucible 12 includes the second thick part 3b disposed between the third segment 2c and the second segment 2b, each having a tubular shape, and the first thick part 3a disposed between the second segment 2b and the first segment 2a, each having a tubular shape, as illustrated in FIG. 2. Strength of the crucible 12 can be further improved by including the plurality of thick parts 3.

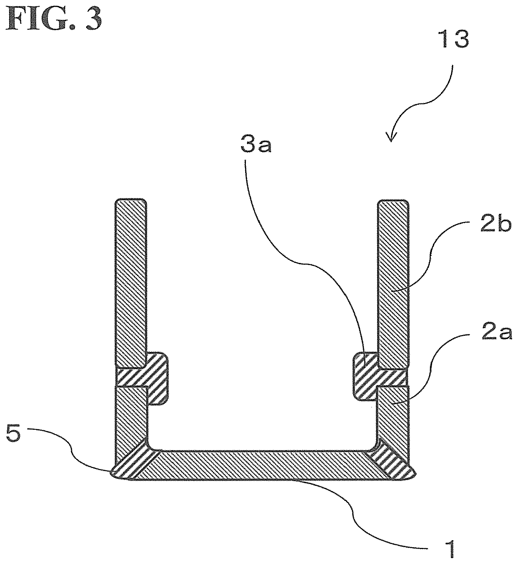

As in the case of a crucible 13 illustrated in FIG. 3, a first thick part 3a may be approximately flush with a tubular part 2 in an outer diameter (outer periphery) of the first thick part 3a, and may have a greater thickness so as to protrude toward an inner diameter side thereof. Even with this embodiment, the crucible 13 has relatively high strength and is less likely to deform.

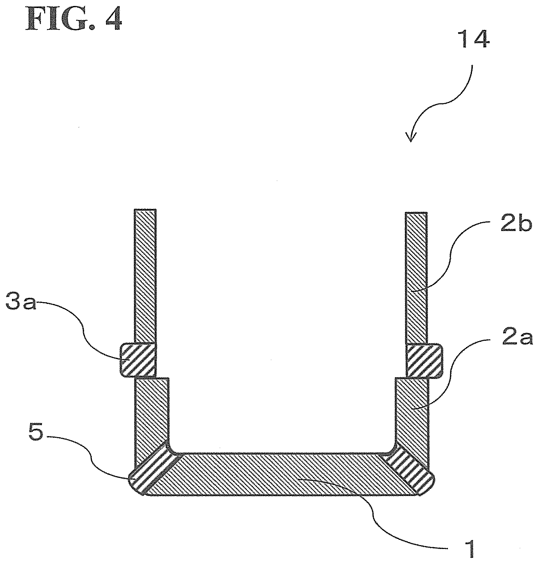

As in the case of a crucible 14 illustrated in FIG. 4, a segment of a tubular part 2 which is located on a side of a bottom part 1 may have a greater thickness than a segment of the tubular part 2 which is located on a side of an opening of the tubular part 2. Specifically, a thickness of a first segment 2a is greater than a thickness of a second segment 2b as illustrated in FIG. 4. This leads to improved strength of a lower region of the crucible 14 which is particularly easily deformable. When an outer diameter of the first segment 2a is approximately equal to an outer diameter of the second segment 2b as illustrated in FIG. 4, the crucible 14 is less likely to deform because the first segment 2a is flush with the second segment 2b, and stress or the like is less likely to be concentrated on an outer peripheral surface which is relatively prone to cracking or the like.

The following is common to the crucibles 10, 12, 13, and 14 in FIGs. 1 to 4, and these crucibles are therefore referred to as "crucible 10" for the sake of simplicity. When the crucible 10 is repeatedly used, crystal grain growth is observable depending on thermal history thereof. Strength of metal usually decreases with increasing grain diameter (Hall-Petch relationship). Cracks or the like tend to develop because grain boundaries push against each other along with the growth of crystal grains, and strength deterioration due to these cracks tends to occur.

The first thick part 3a has the function as a reinforcing ring and the function of blocking the development of cracks thus occurred by the growth of the crystal grains and grain boundaries. Consequently, the development of cracks or the like which particularly tend to occur at a region close to the bottom part 1 is less likely to reach an upper part of the crucible 10.

These thick parts (the first thick part 3a and the second thick part 3b) can be formed, for example, by welding. A metal structure state in joint portions generated by the welding is different from a metal structure state in the tubular part 2 formed, for example, by forging. Specifically, both are remarkably different in crystal grain size. Because the development of cracks or the like is less likely to occur due to the different metal structures, the development of cracks or the like is much less likely to occur by forming the first thick part 3a by welding, and the crucible 10 is much less likely to deform.

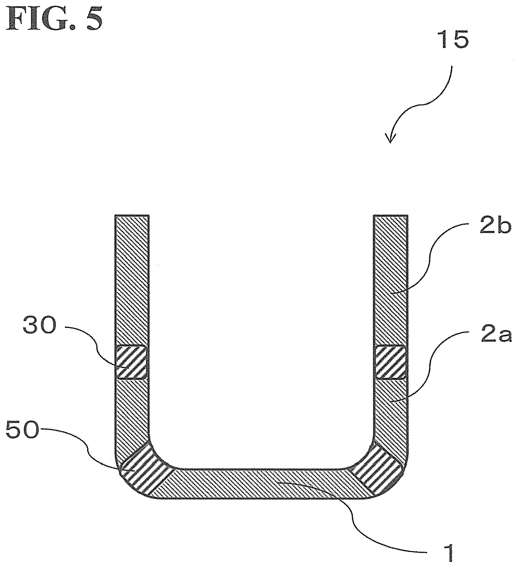

FIGs. 5 to 8 are a sectional view or a side view illustrating other embodiments of the crucible. The crucible 15 illustrated in FIG. 5 includes a bottom part 1 and a tubular part 2 connecting to the bottom part 1. The tubular part 2 is composed of a plurality of segments, and an annular first welded part 30 is disposed at a position at which these segments are adjacent to each other. The crucible 15 also includes a bottom welded part 50 at a boundary portion between the bottom part 1 and the tubular part 2, namely, at a corner portion between the bottom part 1 and the bottom part 2.

In the crucible 15 illustrated in FIG. 5, a thickness of the first welded part 30 is equal to a thickness of each of the segments adjacent thereto (the first segment 2a and the second segment 2b). With the crucible 15 having the above configuration, cracks are less likely to develop because the welded part 30 has a different metal structure, and the crucible 15 is therefore less likely to deform. Alternatively, when mechanical strength of the welded part 30 is enhanced by adjusting welding conditions or the like, the first welded part 30 is capable of functioning as a reinforcing ring. The crucible 15 is therefore much less likely to deform or the like.

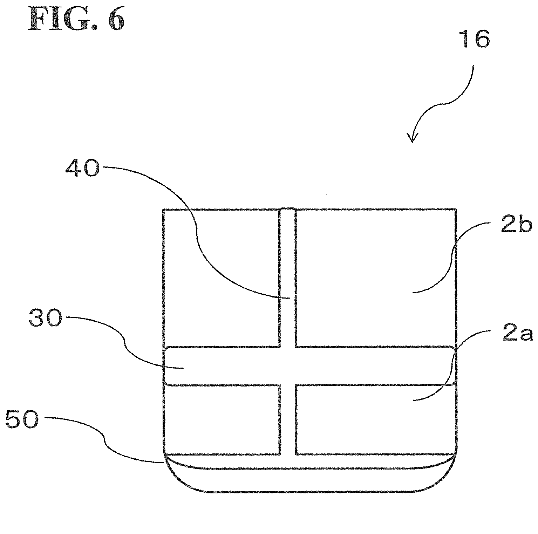

The crucible 16 illustrated in FIG. 6 includes a second welded part 40 which connects to a first welded part 30 and is not parallel to the first welded part 30. With this embodiment, the second welded part 40 is also effective in reducing the development of cracks or the like, and strength of the crucible 16 can be further enhanced. In the crucible 16 illustrated in FIG. 6, the second welded part 40 is orthogonal to the first welded part 30.

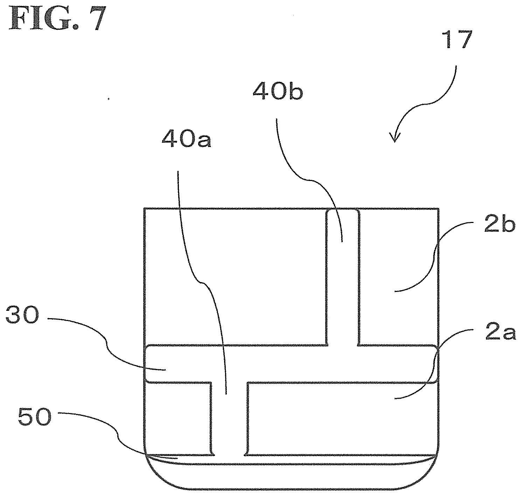

The crucible 17 illustrated in FIG. 7 illustrates an embodiment provided with a second welded part 40a located in a first segment 2a, and a second welded part 40b located in a second segment 2b. The second welded part 40a is separated from the second welded part 40b in a circumferential direction.

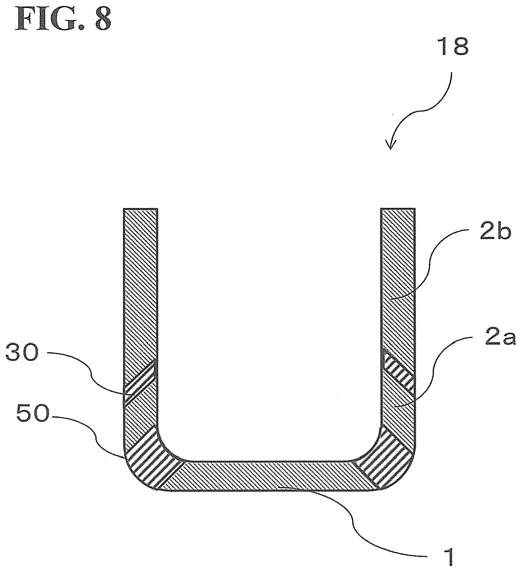

In the crucible 18 illustrated in FIG. 8, a first welded part 30 is inclined downward in a direction from an inner diameter toward an outer diameter. With this embodiment, welding metal is less likely to extend around an inner wall within the crucible. Deformation and peeling-off of the first welded part 30 are relatively less likely to occur, for example, upon application of pressure so that the crucible 10 is widen outward from an inner peripheral side thereof.

The crucible 18 illustrated in FIG. 8 is subject to, for example, repetitive heating and cooling. With the configuration of the crucible 18, however, even if cracks and deformation occur in a lower region (a bottom part 1 and a first segment 2a), a defective portion of the lower region in the crucible 18 (for example, only the first segment 2a) needs to be repaired or replaced, whereas an upper region of the crucible 18 (for example, a second segment 2b in FIG. 4) is repeatedly reusable.

While the plurality of embodiments have been described above, the present invention is not limited to the above-described embodiments and can be carried out in various modifications without departing from the spirit and scope of the present invention. For example, the bottom part 1 may have an elliptical shape or a rectangular shape besides the circular plate shape. For example, the tubular part 2 may have such a shape that is opened wider toward the top.

### <Method for Manufacturing Crucible>

One of embodiments of a method for manufacturing a crucible is described below. The following embodiment illustrates the case of manufacturing the crucible composed of iridium. Firstly, an iridium ingot is manufactured by melting and casting iridium. The ingot is processed into a flat plate by forging and rolling. A circular plate serving as the bottom part 1 and a plurality of rectangular plates serving as a tubular part 2 are cut out from the flat plate.

Subsequently, a first segment 2a and a second segment 2b, each having a cylindrical shape, are formed by making the plurality of rectangular plates into a cylindrical shape, followed by butt welding of their ends. A welded portion of a butted part becomes a segment corresponding to a second welded part 40. As a welding method, arc welding, such as MIG welding (metal inert gas welding) and TIG welding (Tungsten Inert Gas welding), is applicable.

Subsequently, a lower end of the first segment 2a and the circular plate-shaped bottom part 1 are joined together by welding. Thus, a welded part 50 is formed in which the bottom part 1 and the first segment 2a are joined together. Arc welding is similarly applicable as a welding method. Then, an upper end of the first segment 2a and a lower end of the second segment 2b are joined together by welding. Thus, a first welded part 30 is formed in which the first segment 2a and the second segment 2b are joined together. Arc welding is similarly applicable as a welding method. When the first welded part 30 and the bottom welded part 50 are formed by welding, such as arc welding, it is easy to thicken these welded parts. In other words, the shape of the first welded part 30 can be thickened by welding as in the case of the first thick part 3a. Similarly, the shape of the bottom welded part 50 can be thickened as in the case of the welded part 5.

With the above method, it is possible to form the crucible 10 illustrated in FIG. 1 which includes the bottom part 1, the tubular first segment 2a connecting to the bottom part 1, the tubular second segment 2b connecting to the first segment 2a, and the first thick part 3a that joins the first segment 2a and the second segment 2b together, as well as the crucible 17 illustrated in FIG. 7 which includes the first welded part 30.

It is also possible to change the thickness of each of the segments in the tubular part 2 by cutting out rectangular plates respectively serving as the first segment 2a and the second segment 2b from flat plates that are different in thickness. The crucible 14, in which each of the bottom part 1 and the first segment 2a has a greater thickness than the second segment 2b, is obtainable by forming the crucible by cutting out the bottom part 1 and the first segment 2a from a first flat plate having a great thickness, and the second segment 2b from a second flat plate having a small thickness.

Alternatively, butted end surfaces of a rectangular plate which constitute a tubular part 2 (for example, an upper end of a first segment 2a and a lower end of a second segment 2b) may be cut out obliquely when forming a first welded part 30. This makes it possible to obtain a crucible 18 as illustrated in FIG. 8 in which the first welded part 30 is inclined downward from an inner diameter toward an outer diameter. Consequently, the crucible 18 has improved strength and is less likely to deform. Furthermore, slippage is less likely to occur during welding, and welding metal is less likely to extend around an inner wall within the crucible. Also when forming a second welded part 40, the end surfaces of the rectangular plate are obliquely cut out, followed by butt welding in a similar way. This leads to improved strength of the crucible.

### EXAMPLE

Examples of the present embodiment are described below.

Firstly, an iridium ingot manufactured by melting and casting iridium was forged and rolled into flat plates having a thickness of 2 mm. A circular plate of φ 105 mm serving as a bottom part, a rectangular plate of 75 mm × 330 mm serving as a first segment, and a rectangular plate of 75 mm × 330 mm serving as a second segment were cut out from these flat plates. These rectangular plates were processed and their ends were subject to butt welding into a cylindrical tubular part. A crucible was obtained by welding the bottom part and a lower end of the first segment, and by welding an upper end of the first segment and a lower end of the second segment.

As a comparative example, a circular plate of φ 105 mm serving as a bottom part, and a rectangular plate of 150 mm × 330 mm serving as a tubular part were cut out from flat plates having a thickness of 2 mm. These rectangular plates were processed and their ends were subject to butt welding into a cylindrical tubular part. A crucible was obtained by welding the bottom part and a lower end of the tubular part.

Using each of these crucibles, sapphire single crystals were formed by CZ method. A comparison between them showed that deformation (change in outer diameter) of the crucibles before and after use was 2.5 mm in each of the crucibles, thereby achieving great improvement relative to 7.5 mm in the comparative example.

### DESCRIPTION OF THE REFERENCE NUMERAL

- 1: bottom part
- 2: tubular part
- 2a: first segment
- 2b: second segment
- 2c: third segment
- 3: thick part
- 3a: first thick part
- 3b: second thick part
- 5: bottom thick part
- 10, 12, 13, 14, 15, 16, 17, 18: crucible
- 30: first welded part
- 40: second welded part
- 50: bottom welded part

## Claims

1. A crucible, comprising:
a bottom part and a tubular part comprising iridium or platinum as a main ingredient;
the tubular part connected to the bottom part, and comprising a plurality of segments; and
an annular thick part connecting adjacent segments of the plurality of segments.

2. The crucible according to claim 1, wherein the annular thick part is a plurality of annular thick parts.

3. The crucible according to claim 1 or 2, wherein the annular thick part protrudes from an outer periphery of the tubular part.

4. The crucible according to any one of claims 1 to 3, wherein a segment of the tubular part which is adjacent to the bottom part has a greater thickness than another segment of the tubular part which is located adjacent an opening of the tubular part.

5. A crucible, comprising:
a bottom part and a tubular part comprising iridium or platinum as a main ingredient, wherein
the tubular part comprises a plurality of segments, and an annular first welded part connecting adjacent segments of the plurality of segments.

6. The crucible according to claim 5, wherein the annular first welded part is a plurality of annular first welded parts.

7. The crucible according to claim 5 or 6, further comprising a second welded part which connects to the first welded part and is not parallel to the first welded part.
